# EUROPEAN PATENT APPLICATION

(11) **EP 1 143 623 A1**
(43) Date of publication of application: **10.10.2001**
(21) Application number: 01108656.8
(22) Date of filing: 05.04.2001
(51) Int. Cl.: H03L 7/107, H03L 7/095, H03L 7/089

(54) **Adaptive phase comparator and method of phase comparison in a phase locked loop circuit**

(30) Priority: 07.04.2000 JP 2000107121
(71) Applicant: NEC CORPORATION, Tokyo (JP)
(72) Inventor: Matsui, Naohiro, Minato-ku, Tokyo (JP)
(74) Representative: Baronetzky, Klaus, Dipl.-Ing.

(57) **Abstract**

The present invention provides a phase comparator provided in a phase locked loop circuit, the phase comparator converting a phase difference between first and second input signals into a current signal, wherein the phase comparator has : a lock detector for detecting locked and unlocked states of the phase locked loop circuit to generate a detected signal which indicates one of the locked and unlocked states ; and a current source connected to the lock detector for receiving the detected signal from the lock detector and varying a supply current based on the detected signal, so that if the detected signal indicates the unlocked states, then the current source increases the supplying current.

## Description

The present invention relates to a phase comparator and a phase locked loop circuit having the phase comparator a method of phase comparison, and more particularly to a phase comparator of a Gilbert cell mixer type which is provided in a phase locked loop circuit, wherein the phase comparator of the Gilbert cell mixer type receives first and second input signals for converting a phase difference of the first and second input signals into an electrical signal.

The first conventional phase comparator is disclosed in Japanese laid-open patent publication No. 10-233683. The first conventional phase comparator has transistors as active elements, inductances as passive element, resistances and capacitances as well as constant current sources. A current flowing through the transistor is adjusted by a lock detector to adjust a loop gain for realizing a high speed lock-up operation.

The second conventional phase comparator is of the Gilbert cell mixer type. This second conventional phase comparator of the Gilbert cell mixer type is provided in a phase locked loop circuit, wherein the phase comparator of the Gilbert cell mixer type receives first and second input signals for converting a phase difference of the first and second input signals into an electrical signal. This second conventional phase comparator has the constant current source only as the power source. The Gilbert cell mixer type phase comparator performs the lock-up operation on the basis of the constant current supplied from the constant current source independently from the locked-state or unlocked-state of the phase locked loop circuit.

The above first and second conventional phase comparator has the following problems.

The problem with the first conventional phase comparator is as follows. If an active filter is used, then in the locked and unlocked states of the phase locked loop circuit, the current supplied from the constant current source is varied to shorten the lock-up time. If a passive filter is used, then it is difficult to adjust the loop gain. For this reason, when the phase locked loop circuit is placed in the unlocked state, it is difficult to realize an efficient entry of the phase locked loop circuit into the locked state. This means it difficult to shorten the lock-up time. If the loop band of the loop filter is widen in order to shorten the lock-up time, then the unnecessary signal is not removed by the loop filter, whereby a voltage controlled oscillator is modulated by the residual unnecessary signal, resulting increases in a harmonic spurious and in phase noises of the voltage controlled oscillator.

The second conventional phase comparator is incapable of varying the current supplied from the constant current source. In order to shorten the lock-up time, it is necessary to widen the loop band of the loop filter. For this reason, the unnecessary signal is not removed by the loop filter, whereby a voltage controlled oscillator is modulated by the residual unnecessary signal, resulting in the increases in harmonic spurious and in phase noises of the voltage controlled oscillator.

In the above circumstances, it had been required to develop a novel phase comparator free from the above problem.

Accordingly, it is an object of the present invention to provide a novel phase comparator free from the above problems.

It is a further object of the present invention to provide a novel phase comparator capable of shortening the lock-up time without widening the loop band of the loop filter in the phase locked loop circuit.

It is a still further object of the present invention to provide a novel method of phase comparison free from the above problems.

It is yet a further object of the present invention to provide a novel method of phase comparison capable of shortening the lock-up time without widening the loop band of the loop filter in the phase locked loop circuit.

It is another object of the present invention to provide a phase locked loop circuit having a novel phase comparator free from the above problems.

It is still another object of the present invention to provide a phase locked loop circuit having a novel phase comparator capable of shortening the lock-up time without widening the loop band of the loop filter in the phase locked loop circuit.

The first present invention provides a phase comparator provided in a phase locked loop circuit, the phase comparator converting a phase difference between first and second input signals into a current signal, wherein the phase comparator has : a lock detector for detecting locked and unlocked states of the phase locked loop circuit to generate a detected signal which indicates one of the locked and unlocked states ; and a current source connected to the lock detector for receiving the detected signal from the lock detector and varying a supply current based on the detected signal, so that if the detected signal indicates the unlocked states, then the current source increases the supplying current.

The above and other objects, features and advantages of the present invention will be apparent from the following descriptions.

Preferred embodiments according to the present invention will be described in detail with reference to the accompanying drawings.

FIG. 1 is a block diagram illustrative of a phase locked loop circuit having a first novel phase comparator in a first embodiment in accordance with the present invention.

FIG. 2 is a circuit diagram illustrative of the novel phase comparator provided in the phase locked loop circuit of FIG. 1.

FIG. 3 is a circuit diagram illustrative of the conventional phase comparator.

FIG. 4 is a circuit diagram illustrative of the circuit configuration of the novel phase comparator of FIG. 2.

FIG. 5 is a circuit diagram illustrative of a circuit configuration of the novel phase comparator of FIG. 4 to explain the operations thereof.

FIG. 6 is a diagram illustrative of variation in output voltage of the phase comparator verses phase difference.

FIG. 7 is a circuit diagram illustrative of a modified circuit configuration to the novel phase comparator of FIG. 2.

The first present invention provides a phase comparator provided in a phase locked loop circuit, the phase comparator converting a phase difference between first and second input signals into a current signal, wherein the phase comparator has : a lock detector for detecting locked and unlocked states of the phase locked loop circuit to generate a detected signal which indicates one of the locked and unlocked states ; and a current source connected to the lock detector for receiving the detected signal from the lock detector and varying a supply current based on the detected signal, so that if the detected signal indicates the unlocked states, then the current source increases the supplying current.

If the phase locked loop circuit is in the unlocked state, then the lock detector causes the increase in the supplying currcnt from the variable current source to the circuit of the phase comparator. If the phase locked loop circuit is in the locked state, then the lock detector causes the decrease or discontinuation of the supplying current from the variable current source to the circuit of the phase comparator. For those reasons, even if the passive filter is used, then it is possible to shorten the lock-up time without widening the loop band.

It is preferable that if the detected signal indicates the locked states, then the current source decreases the supplying current.

It is further preferable that the current source comprises a pair of a constant current source for supplying a constant current and a variable current source connected to the lock detector for varying a current based on the detected signal.

It is further more preferable that the lock detector is connected between an output terminal of the phase comparator and the variable current source.

It is more over preferable that the phase comparator includes plural current mirror circuits.

It is moreover preferable that each of the plural current mirror circuits comprises a pair of bipolar transistors.

It is further moreover preferable that a base current compensating bipolar transistor is connected to one of the paired bipolar transistors of each of the plural current mirror circuits.

It is still moreover preferable that the base current compensating bipolar transistor has a base connected to a collector of the one of the paired bipolar transistors, and an emitter connected to a base of the one of the paired bipolar transistors.

The second present invention provides a phase locked loop circuit comprising : an input terminal ; an output terminal ; a phase comparator connected to the input terminal ; a loop filter connected to the phase comparator ; a voltage controlled oscillator connected to the loop filter, and the voltage controlled oscillator connected to the output terminal ; a mixer connected to the output terminal and also connected to the phase comparator, so that the phase comparator receives a first input signal from the input terminal and a second input signal from the mixer for converting a phase difference between the first and second input signals into a current signal, wherein the phase comparator has : a lock detector for detecting locked and unlocked states of the phase locked loop circuit to generate a detected signal which indicates one of the locked and unlocked states ; and a current source connected to the lock detector for receiving the detected signal from the lock detector and varying a supply current based on the detected signal, so that if the detected signal indicates the unlocked states, then the current source increases the supplying current.

If the phase locked loop circuit is in the unlocked state, then the lock detector causes the increase in the supplying current from the variable current source to the circuit of the phase comparator. If the phase locked loop circuit is in the locked state, then the lock detector causes the decrease or discontinuation of the supplying current from the variable current source to the circuit of the phase comparator. For those reasons, even if the passive filter is used, then it is possible to shorten the lock-up time without widening the loop band.

It is preferable that if the detected signal indicates the locked states, then the current source decreases the supplying current.

It is further preferable that the current source comprises a pair of a constant current source for supplying a constant current and a variable current source connected to the lock detector for varying a current based on the detected signal.

It is further more preferable that the lock detector is connected between an output terminal of the phase comparator and the variable current source.

It is more over preferable that the phase comparator includes plural current mirror circuits.

It is still more preferable that each of the plural current mirror circuits comprises a pair of bipolar transistors.

It is further moreover preferable that a base current compensating bipolar transistor is connected to one of the paired bipolar transistors of each of the plural current mirror circuits.

It is still moreover preferable that the base current compensating bipolar transistor has a base connected to a collector of the one of the paired bipolar transistors, and an emitter connected to a base of the one of the paired bipolar transistors.

The third present invention provides a method of phase comparison in a phase locked loop circuit by converting a phase difference between first and second input signals into a current signal. The method comprises the steps of : detecting locked and unlocked states of the phase locked loop circuit to generate a detected signal which indicates one of the locked and unlocked states ; and varying a supply current based on the detected signal, so that if the detected signal indicates the unlocked states, then the supplying current is increased.

If the phase locked loop circuit is in the unlocked state, then the lock detector causes the increase in the supplying current from the variable current source to the circuit of the phase comparator. If the phase locked loop circuit is in the locked state, then the lock detector causes the decrease or discontinuation of the supplying current from the variable current source to the circuit of the phase comparator. For those reasons, even if the passive filter is used, then it is possible to shorten the lock-up time without widening the loop band.

It is preferable that if the detected signal indicates the locked states, then the supplying current is decreased.

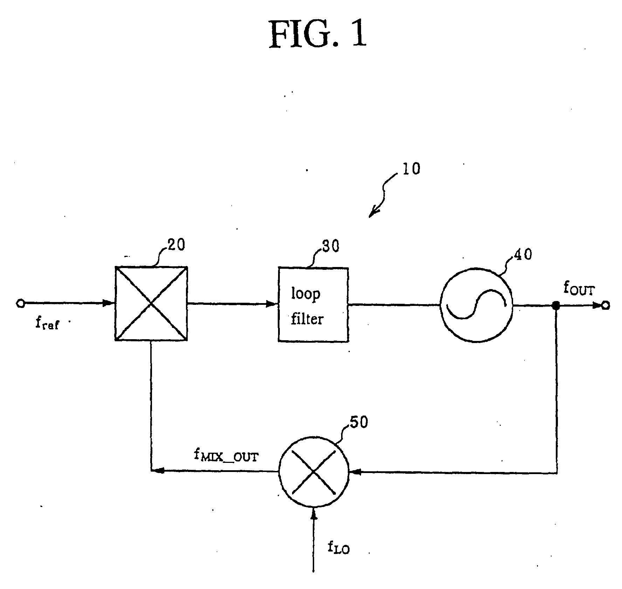

A first embodiment according to the present invention will be described in detail with reference to the drawings. FIG. 1 is a block diagram illustrative of a phase locked loop circuit having a first novel phase comparator in a first embodiment in accordance with the present invention. The phase locked loop circuit 10 has a phase comparator 20 having an input terminal which receives an input of a reference frequency f_{ref}. The phase locked loop circuit 10 also has a loop filter 30 which has an input terminal connected to an output terminal of the phase comparator 20. The phase locked loop circuit 10 also has a voltage controlled oscillator 40 having an input terminal connected to an output terminal of the loop filter 30, wherein an oscillation frequency fₒᵤₜ appears on the output terminal of the loop filter 30. The phase locked loop circuit 10 also has a feed-back path which extends from the output terminal of the voltage controlled oscillator 40 to the phase comparator 20, wherein a mixer 50 is provided on the feed-back path. The mixer 50 receives both the oscillation frequency fₒᵤₜ from the voltage controlled oscillator 40 and a local oscillation signal frequency f_{LO} for calculating a difference between the oscillation frequency fₒᵤₜ and the local oscillation signal frequency f_{LO} to generate a mixer output frequency. fₘᵢₓ₋ₒᵤₜ which corresponds to the difference. The phase comparator 20 receives both the reference frequency f_{ref} as a first input signal and the mixer output frequency fₘᵢₓ₋ₒᵤₜ as a second input signal for comparing in phase the reference frequency f_{ref} and the mixer output frequency fₘᵢₓ₋ₒᵤₜ so as to output a phase difference signal. This phase difference signal is transmitted to the loop filter 30. The loop filter 30 receives the phase difference signal from the phase comparator 20, wherein the phase difference signal includes any unnecessary signal component. The loop filter 30 receives the unnecessary signal component from the phase difference signal to generate a voltage controlled oscillator control voltage which is then transmitted into the voltage controlled oscillator 40.

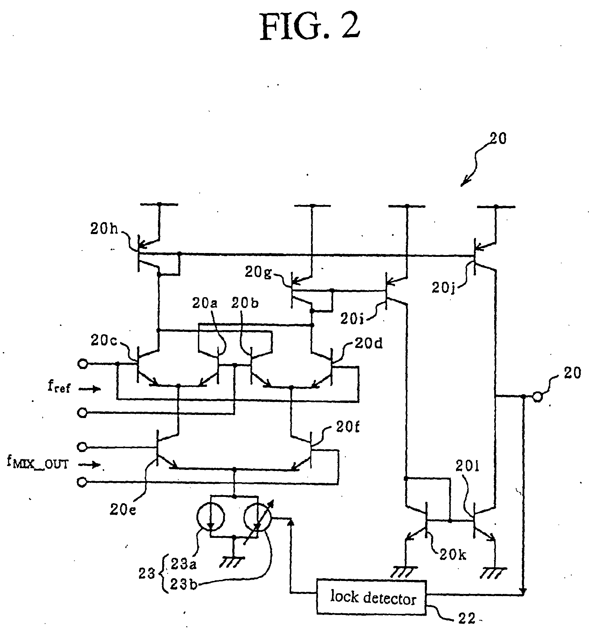

If the phase locked loop circuit 10 is in the locked-state, then the reference frequency f_{ref} and the mixer output frequency fₘᵢₓ₋ₒᵤₜ are equal to each other. If the phase locked loop circuit 10 is in the unlocked-state, then the reference frequency f_{ref} and the mixer output frequency fₘᵢₓ₋ₒᵤₜ are different from each other. The phase comparator 20 in the phase locked loop circuit 10 comprises the Gilbert cell mixer type phase comparator having plural current mirror circuits, and a combination of a lock detector for detecting a locked state of the phase locked loop circuit 10 and a variable current source connected to the lock detector for supplying a current which accords to the phase difference between the reference frequency f_{ref} and the mixer output frequency fₘᵢₓ₋ₒᵤₜ as the first and second input signals. Namely, the variable current source receives a current signal which indicates the locked or unlocked state from the lock detector, so that the variable current source varies the supplying current depending upon the locked or unlocked state. FIG. 2 is a circuit diagram illustrative of the novel phase comparator provided in the phasc locked loop circuit of FIG. 1. The description of the circuit configuration will be made below.

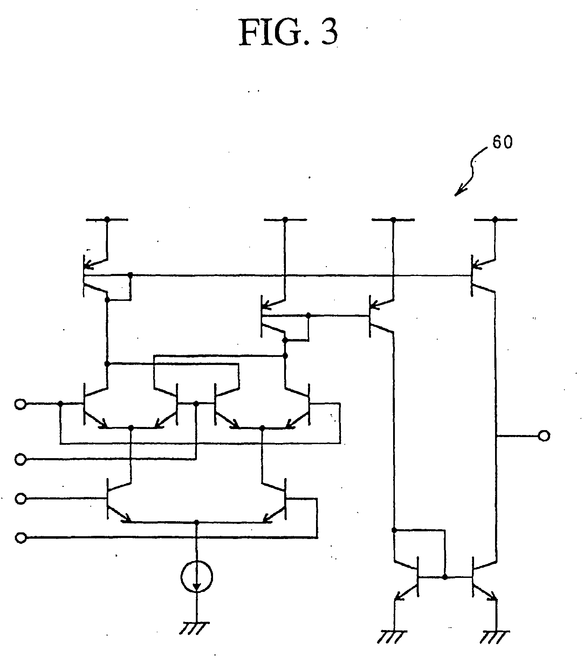

FIG. 3 is a circuit diagram illustrative of the conventional phase comparator. A conventional Gilbert cell mixer type phase comparator 60 is free of any lock detector between a current source and an output terminal of the phase comparator 60, and the current source comprises the constant current source, so that the constant current source supplies a constant current independently from the locked and unlocked states of the phase comparator 60, for which reason in order to improve the high speed lock-up operation, it is necessary to widen the loop band for increasing the gain of the phase comparator, whereby a phase noise of the voltage controlled oscillator is increased.

The novel phase comparator 20 shown in FIG. 2 has additional elements, for example, the locked detector for detecting the locked state of the phase comparator 20 and the variable current source for varying the supplying current depending on the locked and unlocked states in order to improve the high speed lock-up operation without increasing the phase noise of the voltage controlled oscillator.

The novel phase comparator 20 shown in FIG. 2 has the following circuit configuration. The novel phase comparator 20 has first to fourth input terminals 101, 102, 103 and 104, and a single output terminal 200. The novel phase comparator 20 further has first to twelfth bipolar transistors 20a, 20b, 20c, 20d, 20e, 20f, 20g, 20h, 20i, 20j, 20k, and 20l. The novel phase comparator 20 furthermore has a current source 23 which comprises a pair of a constant current source 23a as a first current source and a variable current source as a second current source. The novel phase comparator 20 moreover has a lock detector 22 for detecting the locked state of the novel phase comparator 20.

The first and second input terminals 101 and 102 receive the reference frequency f_{ref}, whilst the third and fourth input terminals 103 and 104 receive the mixer output frequency fₘᵢₓ₋ₒᵤₜ. The first bipolar transistor 20a comprises an n-p-n bipolar transistor. The second bipolar transistor 20a also comprises an n-p-n bipolar transistor. Bases of the first and second bipolar transistors 20a and 20b are connected to each other and also connected to the second input terminal 102 for receiving the reference frequency f_{ref}. The third bipolar transistor 20c comprises an n-p-n bipolar transistor. The fourth bipolar transistor 20d also comprises an n-p-n bipolar transistor. Bases of the third and fourth bipolar transistors 20c and 20d are connected to each other and also connected to the first input terminal 101 for receiving the reference frequency f_{ref}. The fifth bipolar transistor 20e also comprises an n-p-n bipolar transistor. The sixth bipolar transistor 20f also comprises an n-p-n bipolar transistor. A base of the fifth bipolar transistor 20e is connected to the third input terminal 103 for receiving the mixer output frequency fₘᵢₓ₋ₒᵤₜ. A base of the sixth bipolar transistor 20f is connected to the fourth input terminal 104 for receiving the mixer output frequency fₘᵢₓ₋ₒᵤₜ. Emitters of the first and third bipolar transistors 20a and 20c are connected to each other and also connected to a collector of the fifth bipolar transistor 20e. Emitters of the second and fourth bipolar transistors 20b and 20d are connected to each other and also connected to a collector of the sixth bipolar transistor 20f. Emitters of the fifth and sixth bipolar transistors 20e and 20f are connected to each other and also connected to an output terminal of the current source 23. The seventh bipolar transistor 20g comprises a p-n-p bipolar transistor. The eighth bipolar transistor 20h also comprises a p-n-p bipolar transistor. The ninth bipolar transistor 20i also comprises a p-n-p bipolar transistor. The tenth bipolar transistor 20j also comprises a p-n-p bipolar transistor. Collectors of the first and fourth bipolar transistors 20a and 20d are connected to each other and also connected to a collector of the seventh bipolar transistor 20g. Collectors of the second and third bipolar transistors 20b and 20c are connected to each other and also connected to a collector of the eighth bipolar transistor 20h. Bases of the seventh and ninth bipolar transistors 20g and 20i are connected to each other and also connected to the collector of the seventh bipolar transistor 20g. Bases of the eighth and tenth bipolar transistors 20h and 20j are connected to each other and also connected to the collector of the eighth bipolar transistor 20h. Emitters of the seventh, eighth, ninth and tenth bipolar transistors 20g, 20h, 20i and 20j are connected to a high voltage line. The eleventh bipolar transistor 20k comprises an n-p-n bipolar transistor. The twelfth bipolar transistor 20l also comprises an n-p-n bipolar transistor. Collectors of the ninth and eleventh bipolar transistors 20i and 20k are connected to each other. Bases of the eleventh and twelfth bipolar transistors 20k and 20l are connected to each other and also connected to the collectors of the ninth and eleventh bipolar transistors 20i and 20k. Collectors of the tenth and twelfth bipolar transistors 20j and 20l are connected to each other and also connected to the output terminal 200. Emitters of the eleventh and twelfth bipolar transistors 20k and 20l are connected to a ground line.

The current source 23 is connected between the emitters of the fifth and sixth bipolar transistors 20e and 20f and the ground line. The current source 23 comprises a pair of the constant current source 23a and the variable current source 23b which are connected in parallel to each other between the emitters of the fifth and sixth bipolar transistors 20e and 20f and the ground line. The lock detector 22 is connected between the output terminal 200 and the variable current source 23b. The variable current source 23b receives the output from the lock detector 22.

If the phase locked loop circuit 10 is placed in the unlocked state, then an output signal is supplied from the lock detector 22 to the variable current source 23b, whereby the variable current source 23b increase the current, whereby the current supplied to the phase comparator 20 is increased. The increase in the current to the phase comparator 10 increases the loop gain of the phase locked loop circuit 10. The increase in the loop gain of the phase locked loop circuit 10 increases the speed of shifting the unlocked state into the locked state, whereby the lock-up time is shortened. After the phase locked loop circuit 10 is in the locked state, the lock detector 22 detects the locked state, whereby the lock detector 22 supplies the output signal to the variable current source 23b, so that the variable current source 23b reduces the current or discontinues the supply of the current to prevent any further increase in the current of the phase comparator 20.

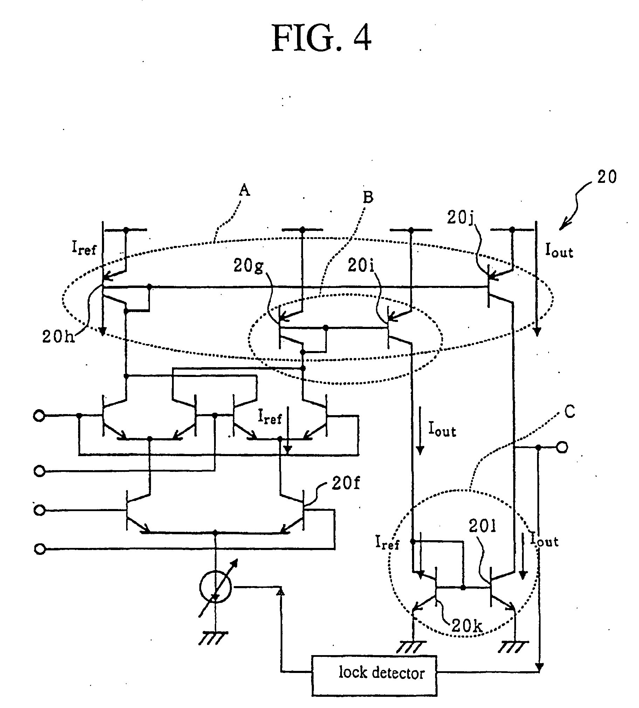

FIG. 4 is a circuit diagram illustrative of the circuit configuration of the novel phase comparator of FIG. 2. The eighth and tenth bipolar transistors 20h and 20j form a first current mirror circuit "A". The seventh and ninth bipolar transistors 20g and 20i form a second current mirror circuit "B". The eleventh and twelfth bipolar transistors 20k and 201 form a third current mirror circuit "C". The first current mirror circuit generates a first output current Iₒᵤₜ which has a predetermined proportion to the first reference current I_{ref}, wherein the first output current Iₒᵤₜ flows through a second branch 2, whilst the first reference current I_{ref} flows through a first branch 1. Further, the plural current mirror circuits perform to mirror the current among the plural current mirror circuits. For example, the second current mirror circuit "B" generates the second mirrored output current Iₒᵤₜ which has a proportion of 1: 1 to the second reference current I_{ref}. The second mirrored output current Iₒᵤₜ becomes the third reference current I_{ref} to the third current mirror circuit "C", whereby the third current mirror circuit "C" generates the third output current mirrored at a predetermine proportion from the third reference current I_{ref}. Accordingly, the second reference current I_{ref} becomes the third output current Iₒᵤₜ of the third current mirror circuit "C".

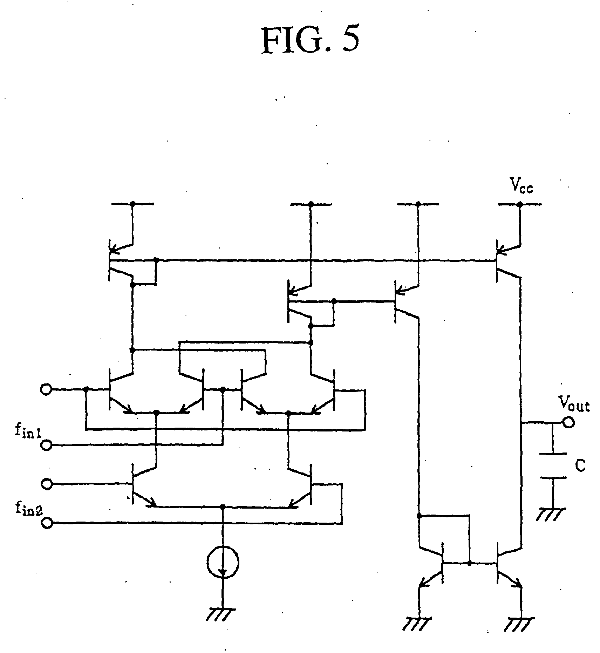

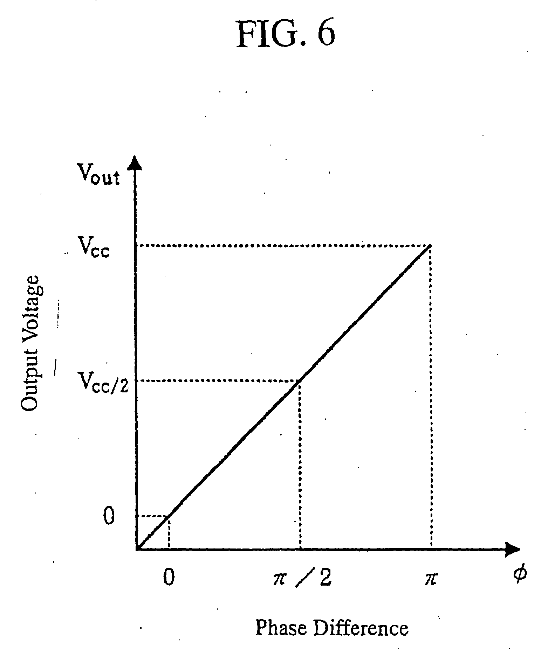

FIG. 5 is a circuit diagram illustrative of a circuit configuration of the novel phase comparator of FIG. 4 to explain the operations thereof. FIG. 6 is a diagram illustrative of variation in output voltage of the phase comparator verses phase difference. The first input frequency fᵢₙ₁ is inputted into the first and second input terminals of the phase comparator and the second input frequency fᵢₙ₂ is inputted into the third and fourth input terminals of the phase comparator. If the first and second input frequencies fᵢₙ₁ and fᵢₙ₂ are different from each other, then the phase comparator serves as a multiplier. If the first and second input frequency fᵢₙ₁ and fᵢₙ₂ are equal to each other, then the phase comparator serves as a phase comparator. When the phase comparator serves as a phase comparator, the frequency component of the phase difference is zero. The phase comparator generates an output DC component which is proportional to a predetermined phase difference between the first and second input frequencies fᵢₙ₁ and fᵢₙ₂. The output current generated based on the predetermined phase difference between the first and second input frequencies fᵢₙ₁ and fᵢₙ₂ is then converted into an output voltage based on the capacitor C which is connected between the output terminal and the ground line. The output voltage passes through the loop filter 30, whereby the unnecessary signal component is removed, and the DC voltage is supplied into the voltage controlled oscillator 40, whereby the voltage controlled oscillator 40 is modulated.

If the phase locked loop circuit 10 is in the unlocked state, the constant current source 23a and the variable current source 23b perform to increase the supplying current to the circuitry of the phase comparator. The loop gain "K" is represented by K ≒(2^{1/2}×Kv×I)/π. The increase in the supplying current causes the increase in the loop gain, whereby the drawing process for causing the reference frequency f_{ref} and the mixer output frequency fₘᵢₓ₋ₒᵤₜ to equal to each other is accelerated.

If the phase locked loop circuit 10 comes into the locked state, and the reference frequency f_{ref} and the mixer output frequency fₘᵢₓ₋ₒᵤₜ become equal to each other, then the DC component is detected from the output terminal of the lock detector 22, whereby the secondary supplying current from the variable current source 23b is reduced or discontinued.

If the phase locked loop circuit 10 is in the unlocked state, then the lock detector 10 causes the increase in the supplying current from the variable current source 23b to the circuit of the phase comparator. If the phase locked loop circuit 10 is in the locked state, then the lock detector 10 causes the decrease or discontinuation of the supplying current from the variable current source 23b to the circuit of the phase comparator. For those reasons, even if the passive filter is used, then it is possible to shorten the lock-up time without widening the loop band.

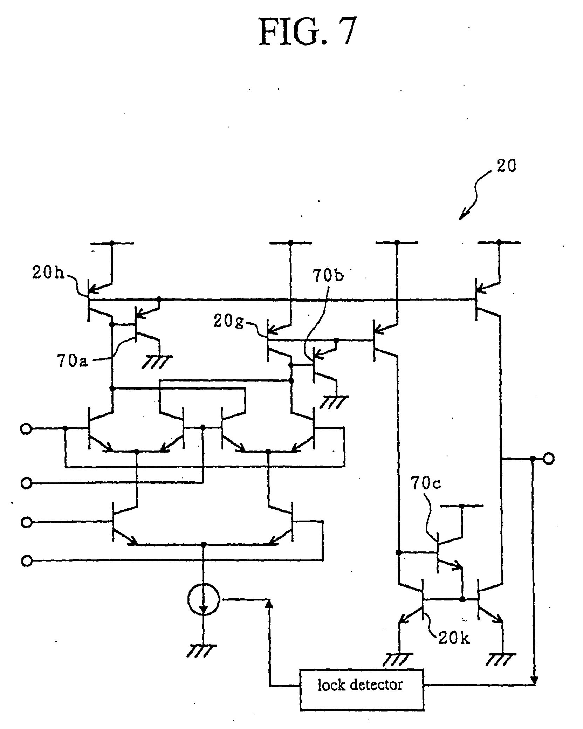

FIG. 7 is a circuit diagram illustrative of a modified circuit configuration to the novel phase comparator of FIG. 2. The modified circuit configuration has additional three bipolar transistors for compensating the base current, for example, first to third base current compensating bipolar transistors 70a, 70b and 70c. The first and second base current compensating bipolar transistors 70a and 70b comprise p-n-p bipolar transistors, whilst the third base current compensating bipolar transistor 70c comprises an n-p-n bipolar transistor. The first base current compensating bipolar transistor 70a has a base connected to the collector of the eighth bipolar transistor 20h, an emitter connected to the base of the eighth bipolar transistor 20h and a collector connected to the ground line. The second base current compensating bipolar transistor 70b has a base connected to the collector of the seventh bipolar transistor 20g, an emitter connected to the base of the seventh bipolar transistor 20g and a collector connected to the ground line. The third base current compensating bipolar transistor 70c has a base connected to the collector of the eleventh bipolar transistor 20k, an emitter connected to the base of the eleventh bipolar transistor 20k and a collector connected to the high voltage line. The first base current compensating bipolar transistor 70a compensates the base current of the eighth bipolar transistor 20h. The second base current compensating bipolar transistor 70b compensates the base current of the seventh bipolar transistor 20g. The third base current compensating bipolar transistor 70c compensates the base current of the eleventh bipolar transistor 20k. If no base current compensation is made, then an error in mirroring ratio of the current mirror circuit is caused at about 1/H_{FE}. If the base current compensation is made, then the error in mirroring ratio of the current mirror circuit is reduced to about 1/(H_{FE}×H_{FE}). The modified circuit configuration using the base current compensation transistors is effective to obtain a highly accurate mirroring proportion.

Whereas modifications of the present invention will be apparent to a person having ordinary skill in the art, to which the invention pertains, it is to be understood that embodiments as shown and described by way of illustrations are by no means intended to be considered in a limiting sense. Accordingly, it is to be intended to cover by claims all modifications which fall within the spirit and scope of the present invention.

## Claims

1. A phase comparator provided in a phase locked loop circuit, said phase comparator converting a phase difference between first and second input signals into a current signal,
**characterized in that** said phase comparator has :
a lock detector for detecting locked and unlocked states of said phase locked loop circuit to generate a detected signal which indicates one of said locked and unlocked states; and
a current source connected to said lock detector for receiving said detected signal from said lock detector and varying a supply current based on said detected signal, so that if said detected signal indicates said unlocked states, then said current source increases said supplying current.

2. The phase comparator as claimed in claim 1, **characterized in that** if said detected signal indicates said locked states, then said current source decreases said supplying current.

3. The phase comparator as claimed in claim 2, **characterized in that** said current source comprises a pair of a constant current source for supplying a constant current and a variable current source connected to said lock detector for varying a current based on said detected signal.

4. The phase comparator as claimed in claim 3, **characterized in that** said lock detector is connected between an output terminal of said phase comparator and said variable current source.

5. The phase comparator as claimed in claim 4, **characterized in that** said phase comparator includes plural current mirror circuits.

6. The phase comparator as claimed in claim 5, **characterized in that** each of said plural current mirror circuits comprises a pair of bipolar transistors.

7. The phase comparator as claimed in claim 6, **characterized in that** a base current compensating bipolar transistor is connected to one of said paired bipolar transistors of each of said plural current mirror circuits.

8. The phase comparator as claimed in claim 7, **characterized in that** said base current compensating bipolar transistor has a base connected to a collector of said one of said paired bipolar transistors, and an emitter connected to a base of said one of said paired bipolar transistors.

9. A phase locked loop circuit comprising :
an input terminal;
an output terminal ;
a phase comparator connected to said input terminal;
a loop filter connected to said phase comparator;
a voltage controlled oscillator connected to said loop filter, and said voltage controlled oscillator connected to said output terminal ;
a mixer connected to said output terminal and also connected to said phase comparator, so that said phase comparator receives a first input signal from said input terminal and a second input signal from said mixer for converting a phase difference between said first and second input signals into a current signal,
**characterized in that** said phase comparator has :
a lock detector for detecting locked and unlocked states of said phase locked loop circuit to generate a detected signal which indicates one of said locked and unlocked states ; and
a current source connected to said lock detector for receiving said detected signal from said lock detector and varying a supply current based on said detected signal, so that if said detected signal indicates said unlocked states, then said current source increases said supplying current.

10. The phase locked loop circuit as claimed in claim 9,
**characterized in that** if said detected signal indicates said locked states, then said current source decreases said supplying current.

11. The phase locked loop circuit as claimed in claim 10,
**characterized in that** said current source comprises a pair of a constant current source for supplying a constant current and a variable current source connected to said lock detector for varying a current based on said detected signal.

12. The phase locked loop circuit as claimed in claim 11,
**characterized in that** said lock detector is connected between an output terminal of said phase comparator and said variable current source.

13. The phase locked loop circuit as claimed in claim 12,
**characterized in that** said phase comparator includcs plural current mirror circuits.

14. The phase locked loop circuit as claimed in claim 13,
**characterized in that** each of said plural current mirror circuits comprises a pair of bipolar transistors.

15. The phase locked loop circuit as claimed in claim 14,
**characterized in that** a base current compensating bipolar transistor is connected to one of said paired bipolar transistors of each of said plural current mirror circuits.

16. The phase locked loop circuit as claimed in claim 15,
**characterized in that** said base current compensating bipolar transistor has a base connected to a collector of said one of said paired bipolar transistors, and an emitter connected to a base of said one of said paired bipolar transistors.

17. A method of phase comparison in a phase locked loop circuit by converting a phase difference between first and second input signals into a current signal, **characterized in that** said method comprises the steps of:
detecting locked and unlocked states of said phase locked loop circuit to generate a detected signal which indicates one of said locked and unlocked states ; and
varying a supply current based on said detected signal, so that if said detected signal indicates said unlocked states, then said supplying current is increased.

18. The method as claimed in claim 17, **characterized in that** if said detected signal indicates said locked states, then said supplying current is decreased.
